# EUROPÄISCHE PATENTSCHRIFT

(11) **EP 1 620 581 B1**
(45) Veröffentlichungstag und Bekanntmachung des Hinweises auf die Patenterteilung: **04.04.2007**
(21) Anmeldenummer: 04739149.5
(22) Anmeldetag: 07.05.2004
(51) Int. Cl.: C23G 5/00, H01L 21/306, B08B 7/00

(54) **PLASMABEHANDLUNG ZUR REINIGUNG VON KUPFER ODER NICKEL**
PLASMA TREATMENT FOR PURIFYING COPPER OR NICKEL
TRAITEMENT AU PLASMA POUR PURIFIER DU CUIVRE OU DU NICKEL

(30) Priorität: 08.05.2003 DE 10320472
(43) Veröffentlichungstag der Anmeldung: 01.02.2006
(73) Patentinhaber: Kolektor Group D.O.O., 5280 Idrija (SI)
(72) Erfinder: MOZETIC, Miran, 5280 Idrija (SI); CVELBAR, Uros, 5280 Idrija (SI)
(74) Vertreter: Grättinger, Günter
(86) Internationale Anmeldenummer: PCT/EP2004/004904
(87) Internationale Veröffentlichungsnummer: WO 2004/098259

(56) Entgegenhaltungen:
- DE-A- 4 034 842
- DE-A- 4 228 551
- DE-A- 4 414 263
- DE-A- 19 644 153
- DE-A- 19 717 698
- DE-A- 19 903 243
- US-A- 5 882 423
- US-A- 5 938 854
- US-A- 6 107 192
- US-A1- 2003 062 333

## Beschreibung

### TECHNISCHES GEBIET

Die vorliegende Erfindung betrifft ein Verfahren zur Behandlung, insbesondere zur Reinigung elektronischer Bauelemente, die aus Kupfer oder Nickel oder ihren Legierungen wie etwa Messing hergestellt sind oder damit überzogen sind, unter Verwendung reaktiver Plasmen.

### HINTERGRUND DER ERFINDUNG

Bauelemente, die aus Kupfer oder Nickel oder ihren Legierungen wie etwa Messing hergestellt sind oder damit überzogen sind, sind typischerweise mit einer Schicht von Verunreinigungen bedeckt. Es ist immer zumindest eine native Schicht von Oxid auf der Oberfläche vorhanden. Häufiger sind die Bauelemente auch mit verschiedenen organischen und anorganischen Verunreinigungen verschmutzt. Organische Verunreinigungen sind oft Rückstände von Öl oder Fett, das während der Bearbeitung aufgebracht wurde. Anorganische Verunreinigungen beinhalten Oxide wie auch Chloride und Sulfide. Die Dicke anorganischer Verunreinigungen auf Oberflächen hängt von der Umgebung, in der die Bauelemente gelagert wurden, wie auch von der Temperatur ab. Je höher die Temperatur ist, desto dicker ist die Schicht von anorganischen Verunreinigungen.

Die Schicht von Verunreinigungen auf Bauelementen sollte vor der Weiterverarbeitung, insbesondere dem Drucken, Lackieren, Kleben, Löten oder Schweißen entfernt werden, um eine gute Verarbeitungsqualität zu gewährleisten.

### STAND DER TECHNIK

Herkömmliche Verfahren der Reinigung von Oberflächen metallischer Bauteile beinhalten mechanische und chemische Behandlungen. Eine mechanische Reinigung wird oft durch Bürsten oder Sandstrahlen durchgeführt, während eine chemische Reinigung durch Eintauchen der Bauelemente in eine Lösung von Chemikalien gefolgt von einem Abspülen mit destilliertem Wasser und anschließendem Trocknen durchgeführt wird.

Keines dieser Verfahren gewährleistet jedoch eine perfekte Reinheit der Bauelemente. Es besteht noch immer eine dünne Schicht an Verunreinigungen an der Oberfläche. Für eine anschließende Hochtemperaturverarbeitung wie Schweißen und Hartlöten ist dies normalerweise günstig, zumindest nicht schädlich. Jedoch liegt auf dem Gebiet der Mikroelektronik die gewünschte Reinheit im allgemeinen jenseits der Grenzen der herkömmlichen Verfahren; denn bei einer Niedertemperaturverarbeitung wie Kleben, Lackieren und Drucken, wie sie bei elektronischen Bauteilen häufig stattfindet, können oberflächliche Restverunreinigungen, die Verarbeitungsqualität beeinflussen. Daher besteht ein Bedarf an einem verbesserten Reinigungsvorgang, um alle Oberflächenverunreinigungen zu entfernen und eine faktisch atomar reine Oberfläche zu erhalten.

Was speziell Kupfer betrifft, so wird dieses Element gegenwärtig als ein Zwischenverbindungsmaterial betrachtet, da Kupfer einen geringen spezifischen Widerstand und eine vergleichsweise hohe Strombelastbarkeit aufweist. Kupfer ist jedoch für eine Oxidation sehr anfällig. Bei Kupferablagerungen wird die Oxidation als ein Nachteil betrachtet, und sie stört die Haftung an der benachbarten Schicht, beeinträchtigt die Leitfähigkeit des Kupferstrukturelements und verringert die Verläßlichkeit des gesamten Schaltkreises. Daher wird ein äußerst wirksames Verfahren zum Reinigen von Kupferablagerungen in Vorrichtungen mit integrierten Schaltkreisen benötigt.

Neuartige Reinigungsverfahren wurden in einem oder mehreren Schritten der Herstellung von Vorrichtungen mit integrierten Schaltkreisen angewendet. Die neuartigen Verfahren beruhen auf der Anwendung eines ungleichgewichtigen Zustands von Gasen - häufig ein Niederdruckplasma, wie dies beispielsweise in dem Artikel "Plasmaverfahren in der Elektronikfertigung" von J. Messelhäuser, mo, Jahrg. 55 (2001) 8, S. 33 bis 36, beschrieben ist, oder ein Nachglühen, das reich an reaktiven Teilchen ist. Sie wurden zur Entfernung sowohl organischer als auch anorganischer Verunreinigungen, die während der Herstellungsphasen auf Oberflächen auftreten, wie auch zur Reinigung der Herstellungskammer benutzt.

Ein solches, mit angeregten Gasen arbeitendes Verfahren zur Reinigung der Oberfläche von integrierten Schaltungen ist beispielsweise der US 5882423 A entnehmbar. Im einzelnen offenbart dieses Dokument ein zweistufiges Verfahren zur Plasmareinigung von (elektronischen) Bauteilen, die ggfs. mit Nickel oder Nickel-Legierungen überzogen sein können, umfassend die folgenden Schritte:
- Anordnen der Bauteile in einer Plasmakammer;
- Evakuieren der Behandlungskammer;
- Einleiten von 50% Sauerstoff und 50% Argon bzw. Edelgas in die Plasmakammer;
- Erstellen eines Drucks im Bereich von 0.133 bis 0.666 mbar, bevorzugt 0.666 mbar für 20 Minuten in der Behandlungskammer und Anregen eines Plasmas in der Kammer durch einen Hochfrequenzgenerator mit einer Frequenz von 14.56 MHz;
- Auspumpen der Kammer;
- Einleiten von Wasserstoff oder 50% Wasserstoff und 50% Ammoniak in die Plasmakammer;
- Erstellen eines Drucks im Bereich von 0.133 bis 0.666 mbar, bevorzugt 0.666 mbar für 10 Minuten in der Behandlungskammer und Anregen eines Plasmas in der Kammer durch einen Hochfrequenzgenerator mit einer Frequenz von 14.56 MHz.

Durch die Abfolge einer oxidierenden Reinigungsphase und einer reduzierenden Reinigungsphase soll eine weitgehende Reinigung der Bauelemente erreicht werden.

Auch in der deutschen Offenlegungsschrift DE 19702124 A1 wird ein Verfahren zum Reinigen der Oberflächen von Werkstücken beschrieben. Demgemäß können hierfür verschiedene Gase, alleine oder als zwei- oder mehrkomponenten Gasgemische, zur Erzeugung eines Plasmas eingesetzt werden. Die DE 4034842 C2 beschreibt ein plasmachemisches Reinigungsverfahren mit Sauerstoff und Wasserstoff als aufeinanderfolgende Arbeitsgase und eine anschließende PVD- oder PECVD-Beschichtung von Metallsubstraten. Hierbei erfolgt eine Anregung des Plasmas mit Frequenzen im Mikrowellenbereich, wobei hiermit ein hoher Anteil an Radikalen sowie an Ionen angestrebt wird. Eine weitere Möglichkeit der Vorbehandlung einer Oberfläche wird in der japanische Patentanmeldung JP 62158859 A beschrieben, bei der die Oberfläche zunächst mit Ionen eines Edelgases und dann mit Wasserstoff-Ionen beschossen wird.

Kupferreinigungsverfahren, die eine Plasmareinigung umfassen, wurden in verschiedenen Zusammenhängen beschrieben und patentiert, z.B. als eine Bearbeitung, die während der Herstellung von Vorrichtungen mit integrierten Schaltkreisen als Verfahren zur Vorreinigung angewendet wird (US 6,107,192, TW 411497, FR 2801905), zur Entfernung der Oxidschicht auf Seitenwänden, Verbindungen und Durchgängen (TW 471126, US 2001-049,181, US 6,323,121, US 6,309,957, US 6,204,192, EP-1 041 614, WO 00/29642) oder auf Kupferanschlußstellen (WO 02/073687, US 2002-127,825), oder zur Verbesserung der Kupferverfahrensintegration (US 6,395,642), oder zur Reinigung von Vorrichtungen mit integrierten Halbleiterschaltkreisen, die vergrabene Zwischenverbindungen aufweisen, welche Kupfer in den Hauptleiterschichten aufweisen (US 2002-042,193). Das empfohlene Gas für die Kupferreinigung ist ein Gemisch aus Wasserstoff und Stickstoff, oder Ammoniak. In der Patentschrift TW 471126 wird ein Gemisch aus Argon und Wasserstoff empfohlen. Dieses Gemisch ist auch zur Entfernung fluorhaltiger Ätzrückstände geeignet (TW 472319).

Die Plasmareinigung wurde auch als ein Verfahren zur Entfernung von abgelagerten Ätznebenprodukten von Oberflächen einer Halbleiterverarbeitungskammer nach einem Kupferätzvorgang patentiert (US 6,352,081, TW 466629, WO 01/04936). Dieses Verfahren umfaßt die Aufbringung eines oxidierenden Plasmas und eines Plasmas, das eine reaktive Fluorart enthält.

### KURZDARSTELLUNG DER ERFINDUNG

Die vorliegende Erfindung hat sich zum Ziel gesetzt, ein Verfahren zur Behandlung von elektronischen Bauteilen, die aus Kupfer oder Nickel oder ihren Legierungen untereinander oder mit anderen Materialien wie etwa Messing hergestellt sind oder damit überzogen sind, zu schaffen, durch welches die Oberfläche der betreffenden Bauteile gereinigt und in besonderer Weise für eine anschließende Niedertemperaturverarbeitung mit höchster Qualität vorbereitet werden.

Gelöst wird diese Aufgabenstellung durch das in Anspruch 1 angegebene Verfahren. Demnach werden gemäß der vorliegenden Erfindung die Bauteile nacheinander einem Sauerstoffplasma und einem Wasserstoffplasma ausgesetzt, um zunächst organische und anschließend oxidative Verunreinigungen zu beseitigen, wobei während der beiden Plasmabehandlungsschritte spezifische Bedingungen hinsichtlich des Drucks in der Behandlungskammer (10⁻¹ bis 50 mbar), der Art der Anregung des Plasmas in der Kammer (durch einen Hochfrequenzgenerator mit einer Frequenz von mehr als etwa 1 MHz) und der Intensität des Einwirkens von Sauerstoffradikalen auf die Bauelemente (der Fluß der Radikale auf die Bauteiloberfläche übersteigt etwa 10²¹ Radikale pro Quadratmeter) eingehalten werden. Hierdurch wird die Weiterverarbeitung begünstigt, indem insbesondere das anschließende Anhaften von Klebstoff oder Lötmetall auf der Oberfläche verbessert und der Widerstand von Verbindungsstellen verringert wird. Dieses Verfahren ist eine hinsichtlich der Umwelt günstige Alternative zu industriellen Reinigungsvorgängen, die gegenwärtig die nasse chemische Reinigung einsetzen.

Die vorliegende Erfindung stellt ein Verfahren zur Entfernung organischer und anorganischer Verunreinigungen von Oberflächen von elektronischen Bauelementen, die aus Kupfer oder Nickel oder ihren Legierungen wie etwa Messing hergestellt sind oder damit überzogen sind, bereit. Die Bauelemente werden in einer Vakuumkammer angeordnet, die vorzugsweise auf einen Druck von 10 Pa oder weniger evakuiert wird. Die Kammer wird sodann mit einem oxidierenden Gas gefüllt. In der bevorzugten Ausführungsform ist das oxidierende Gas reiner Sauerstoff oder ein Gemisch von Argon oder einem sonstigen Edelgas mit Sauerstoff und ist der gesamte Druck 10 bis 5000 Pa. Gemäß einer alternativen Ausführungsform kann auch die Einbringung von Wasserdampf oder eines Gemisches von Argon oder einem sonstigen Edelgas mit Wasserdampf vorgesehen sein. Argon kann durch jedwedes Edelgas ersetzt werden. Ein Plasma wird durch eine Hochfrequenzentladung angeregt. Sauerstoffradikale, die in der Entladung erzeugt werden, treten in Wechselwirkung mit den organischen Oberflächenverunreinigungen und oxidieren sie zu Wasser und Kohlenstoffoxid, die aus der Oberfläche desorbiert und abgepumpt werden. Nach der oxidierenden Plasmabehandlung wird die Oberfläche frei von organischen Verunreinigungen.

Anorganische Verunreinigungen (hauptsächlich Kupfer- oder Nickeloxide) werden durch Einbringung von Wasserstoff oder eines Gemisches von Argon und Wasserstoff in die Vakuumkammer entfernt. Argon kann durch jedwedes Edelgas ersetzt werden. Ein Plasma wird durch eine Hochfrequenzentladung angeregt. Wasserstoffradikale, die in der Entladung erzeugt werden, treten in Wechselwirkung mit den anorganischen Oberflächenverunreinigungen und reduzieren sie zu Wasser und anderen einfachen Molekülen wie HC1, H₂S, HF usw., die aus der Oberfläche desorbiert und abgepumpt werden. Nach der Wasserstoffplasmabehandlung wird die Oberfläche faktisch frei von jedweden Verunreinigungen.

Ein besonderer Aspekt der vorliegenden Erfindung ist darin zu sehen, daß aufgrund der spezifischen Bedingungen während der Behandlung kein oder nur ein geringer Beschuß der Oberfläche mit hochenergetischen Ionen erfolgt, was sich als besonders günstig erweist.

Bei der Verwendung des erfindungsgemäßen Verfahrens zur Behandlung von elektronischen Bauelementen, die aus Kupfer oder Nickel hergestellt sind oder damit überzogen sind, gibt es eine Anzahl von klaren Vorteilen. Es ermöglicht eine gute Haftung von jedwedem auf der Oberfläche abgelagertem Material einschließlich Klebstoff, Farbe und Niedertemperatur-Lötmetall, es stellt eine gute elektrische Leitfähigkeit durch die Kontaktfläche von Bauelement und Überzug sicher, es ist ökologisch günstig, und seine Betriebskosten und seine Wartung sind minimal. Die Erfindung berücksichtigt dabei die erkenntnis, daß die Plasmabearbeitung durch die Verringerung des Gehalts an Verunreinigungen an der Oberfläche der Bauelemente die Haftung der benachbarten Schicht erhöht und den elektrischen Widerstand durch die Verbindungsfläche verringert.

Die erfindungsgemäß plasmabehandelte Oberfläche ist passiviert, was zu einer längeren Widerstandsfähigkeit gegenüber einer Luft- oder Wasserkorrosion führt. Daneben ermöglicht eine solche Oberfläche eine sehr gute Haftung eines jedweden auf der Oberfläche abgelagerten Materials einschließlich Klebstoff, Farbe und Lötmetall.

### KURZE BESCHREIBUNG DER ZEICHNUNGEN

Figur 1 ist eine schematische Darstellung des Systems, die ein Beispiel eines Systems darstellt, das zur Plasmareinigung von Kupfer oder Nickel bestimmt ist.

Figur 2a ist ein AES (Auger-Elektronenspektroskopie)-Tiefenprofilschaubild, das eine Konzentration von chemischen Elementen auf der nichtbehandelten Kupferprobenoberfläche als eine Funktion der Sputterzeit darstellt.

Figur 2b ist ein AES-Tiefenprofilschaubild, das eine Konzentration von chemischen Elementen auf der naß chemisch behandelten Kupferprobenoberfläche als eine Funktion der Sputterzeit darstellt.

Figur 2c ist ein AES-Tiefenprofilschaubild, das eine Konzentration von chemischen Elementen auf der sauerstoffplasmabehandelten Kupferprobenoberfläche als eine Funktion der Sputterzeit darstellt.

Figur 2d ist ein AES-Tiefenprofilschaubild, das eine Konzentration von chemischen Elementen auf der sauerstoff- und wasserstoffplasmabehandelten Kupferprobenoberfläche als eine Funktion der Sputterzeit darstellt.

### AUSFÜHRLICHE BESCHREIBUNG VON AUSFÜHRUNGSBEISPIELEN DER ERFINDUNG

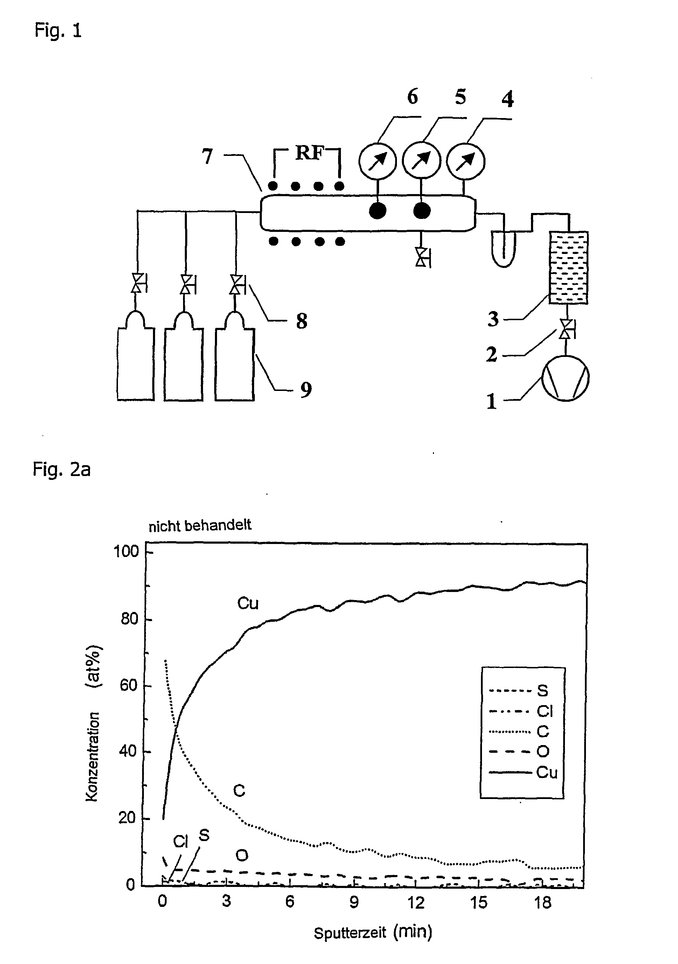

Ein Beispiel eines Systemaufbaus zur Plasmabehandlung von Kupfer oder Nickel ist in der schematischen Darstellung von Figur 1 gezeigt. Das System besteht aus einer Entladungskammer 7, einer Vakuumpumpe 1 mit einem Ventil 2, einem Auffanggefäß mit Sieben 3, drei unterschiedlichen Ausströmventilen 8 und drei Gasflaschen 9 - Sauerstoff, Wasserstoff und ein anderes Gas (insbesondere Edelgas), und ergibt eine wirksame und wirtschaftliche Behandlung. Die Plasmaparameter während des Ätzvorgangs wie die Dosis der Radikale in der Entladungskammer werden durch ein Vakuummeter 4 und zwei oder mehr Sonden wie etwa katalytische Sonden 5 und Langmuir-Sonden 6 kontrolliert. Der Fluß der Radikale wird auf mehr als etwa 10²¹, vorzugsweise mehr als 10²² oder, noch günstiger, mehr als 10²⁴ Radikale pro Quadratmeter pro Sekunde eingestellt.

Die Geschwindigkeit, mit der die Radikale im gasförmigen Plasma, das ein oxidierendes Gas (vorzugsweise Sauerstoff oder Wasserdampf) enthält, gebildet werden, hängt von der Leistung der Entladungsquelle ab. Die Leistung liegt vorzugsweise zwischen 30 und 1000 W pro Liter des Entladungsvolumens, um die Bildung eines eher homogenen Plasmas in einem Druckbereich zwischen 10 und 5000 Pa sicherzustellen. Das Gas kann ein Gemisch aus Argon und oxidierendem Gas mit einem solchen Verhältnis zwischen den Gasen sein, daß die höchste Konzentration von Sauerstoffradikalen im Plasma gestattet wird. Das Plasma wird durch einen Hochfrequenzgenerator erzeugt, der vorzugsweise induktiv gekoppelt ist. Die Frequenz beträgt dabei mehr als etwa 1 MHz, vorzugsweise mehr als 3 MHz, damit eine Erhitzung von Ionen verhindert wird. Da die Frequenz mit einem Hochfrequenzgenerator erzeugt wird, liegt sie nicht im Mikrowellenbereich. In Verbindung mit der induktiven Koppelung des Hochfrequenzgenerators kann hierdurch zudem verhindert werden, daß Ionen mit einer Energie von mehr als 50 eV auf die Bauteile treffen. Es wird angenommen, daß energetische Ionen ein Sputtern des Materials von der Bauelementenoberfläche verursachen würden, wenn die Frequenz des Plasmagenerators unter 3 MHz liegen würde. Es wird angenommen, daß die Entfernung organischer Verunreinigungen durch Sauerstoffradikale durch eine reine Potentialwechselwirkung der Radikale mit den organischen Oberflächenverunreinigungen verursacht wird. Die Entfernungsgeschwindigkeit bei Raumtemperatur liegt zwischen 10 und 100 nm/Minute. Da eine kennzeichnende Dicke von organischen Verunreinigungen auf Bauelementen in einer Größenordnung von 10 nm liegt, beträgt die Reinigungszeit in einem gasförmigen Plasma, das ein oxidierendes Gas enthält, etwa eine Minute. Die Flußgeschwindigkeit des Gases durch das Vakuumsystem liegt bevorzugt in einem Bereich von etwa 100 bis 10000 sccm pro m² behandelter Oberfläche, beträgt jedoch besonders bevorzugt, umgerechnet auf Normbedingungen, mehr als 1 Liter pro Minute (1000 sccm) pro m² behandelter Oberfläche, damit eine rasche Entfernung der Reaktionsprodukte sichergestellt ist. Während der Sauerstoffplasmabehandlung wird auf der Oberfläche von Bauelementen eine Oxidschicht gebildet (Figur 2c).

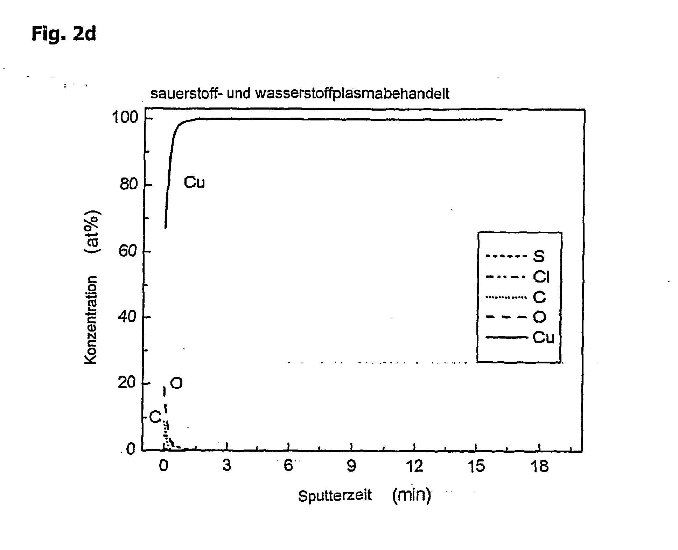

Dünne Filme von Oxiden auf Oberflächen von Kupfer oder Nikkel oder ihren Legierungen werden am besten durch Einleitung eines gasförmigen Plasmas, das aus reinem Wasserstoff oder einem Gemisch aus Wasserstoff und einem Edelgas, vorzugsweise Argon, besteht, zu reinen Metallen reduziert. Die Geschwindigkeit, mit der Wasserstoffradikale im gasförmigen Plasma, das Wasserstoff enthält, gebildet werden, hängt von der Leistung der Entladungsquelle ab. Die Leistung liegt vorzugsweise zwischen 30 und 1000 W pro Liter des Entladungsvolumens, um die Bildung eines eher homogenen Plasmas in einem Druckbereich zwischen 10 und 5000 Pa sicherzustellen. Das Gas kann ein Gemisch aus Argon und Wasserstoff mit einem solchen Verhältnis zwischen den Gasen sein, daß die höchste Konzentration von Wasserstoffradikalen im Plasma gestattet wird. Das wasserstoffhaltige Plasma wird vorzugsweise durch den gleichen Generator und im gleichen Vakuumsystem wie das sauerstoffradikalhaltige Plasma erzeugt. Alternativ können die Wasserstoffradikale jedoch auch durch eine Gleichstrom-Glimmentladung erzeugt werden. Die Proben können durch eine zusätzliche Gleichstromspannung negativ gegen die Wand der Entladungskammer vorgespannt sein. Es wird angenommen, daß die Reduktion der oxidierenden Verunreinigungen durch Wasserstoffradikale durch eine reine Potentialwechselwirkung der Radikale mit den Oberflächenverunreinigungen verursacht wird. Die Reduktionsgeschwindigkeit bei Raumtemperatur beträgt zwischen 1 und 10 nm/Minute. Da eine kennzeichnende Dicke von Oxidschichten auf Bauelementen in einer Größenordnung von 10 nm liegt, beträgt die Reinigungszeit in einem gasförmigen Plasma, das ein oxidierendes Gas enthält, wenige Minuten. Die Flußgeschwindigkeit des Gases durch das Vakuumsystem liegt bevorzugt in einem Bereich von etwa 100 bis 10000 sccm pro m² behandelter Oberfläche, beträgt jedoch besonders bevorzugt, umgerechnet auf Normbedingungen, mehr als 1 Liter pro Minute pro m² behandelter Oberfläche, damit eine rasche Entfernung der Reaktionsprodukte sichergestellt ist. Während der Wasserstoffplasmabehandlung wird die Oxidschicht völlig reduziert. Viele andere oxidierende Verunreinigungen einschließlich Chloriden und Sulfiden werden ebenfalls reduziert. Die Wasserstoffplasmabehandlung gewährleistet daher eine faktisch atomar reine Oberfläche (Figur 2d).

Der Reinigungsvorgang beinhaltet daher eine Behandlung mit Sauerstoffradikalen gefolgt von einer Behandlung mit Wasserstoffradikalen. Falls die Menge an organischen Verunreinigungen gering ist, kann eine Behandlung nur mit Wasserstoffradikalen angewendet werden. Es wird angenommen, daß Wasserstoffradikale auch mit organischen Verunreinigungen reagieren, doch ist die Reaktionsgeschwindigkeit geringer als jene von Sauerstoffradikalen.

In Figur 2a ist ein Beispiel einer nichtbehandelten Kupferoberfläche gezeigt. Die Oberfläche ist mit verschiedenen Verunreinigungen, die während der mechanischen Behandlung auf der Oberfläche zurückbelassen wurden, verschmutzt. Die Art und die Konzentration der Verunreinigungen in der dünnen Probenoberflächenschicht wurde durch Auger-Elektronenspektroskopie (AES)-Tiefenprofilierung in einer PHI545-Scanning-Auger-Mikrosonde mit einem Basisdruck in der Vakuumkammer von unter 1,3 x 10⁻⁷ Pa bestimmt. Ein statischer Primärelektronenstrahl mit einer Energie von 3 keV, einem Strom von 3,5 µA und einem Strahldurchmesser von etwa 40 µm wurde verwendet. Der Einfallswinkel des Elektronenstrahls in bezug auf die Senkrechte zur Oberflächenebene war 47 Grad. Die Proben wurden unter Verwendung von zwei symmetrisch geneigten Ar⁺-Ionenstrahlen mit der kinetischen Energie von 1 keV gesputtert, wodurch eine Ätzung der Probe gewährleistet wurde. Die Sputterzeit entspricht der Tiefe, d.h., eine Minute entspricht 4 nm. Die atomaren Konzentrationen wurden aus den Auger-Spitze-zu-Spitze-Höhen durch Anwenden der relativen elementaren Empfindlichkeitsfaktoren S_{Cu} = 0,22, S_{C}= 0,18, S_{O} = 0,50, S_{S} = 0,80 und S_{Cl}= 1,05 als eine Funktion der Sputterzeit quantifiziert.

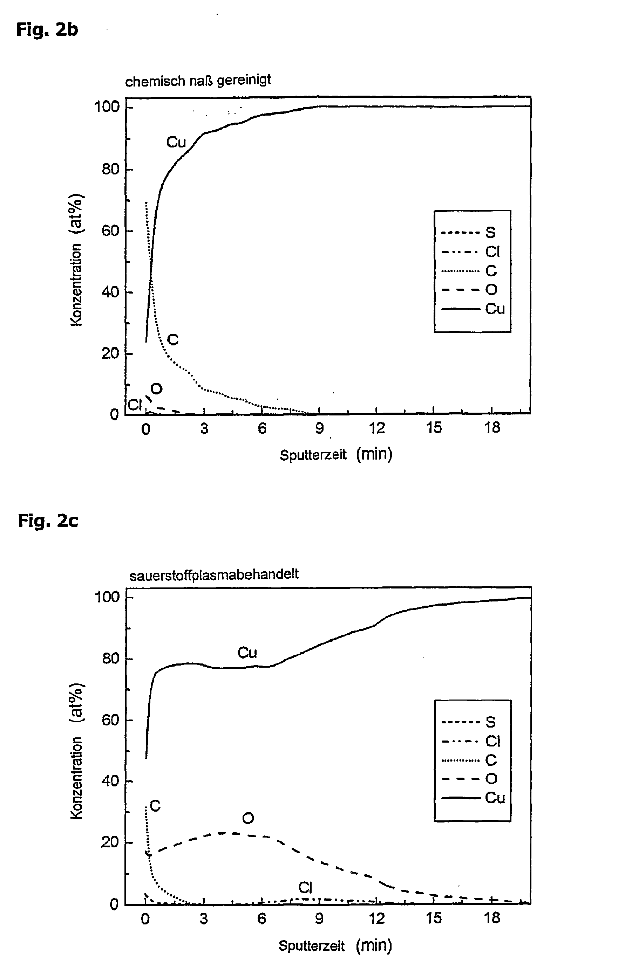

Das Tiefenprofil der Probe nach der nassen chemischen Reinigung ist in Figur 2b gezeigt. Die Proben wurden mit Tetrachlorethylen gereinigt und dann sorgfältig mit destilliertem Wasser abgespült. Es ist bemerkbar, daß die Dicke eines Kohlenstoffilms verringert wurde, aber nach wie vor etwas Kohlenstoff in der oberen dünnen Oberflächenschicht weiterbesteht. Die Dicke des Verunreinigungsfilms wurde von nichtgereinigten Proben durchschnittlich um mehr als einen Faktor von Drei verringert.

Das AES-Tiefenprofil einer Probe, die einem Sauerstoffplasma mit etwa 7 × 10²⁴ Radikalen pro Quadratmeter ausgesetzt war, ist in Figur 2c gezeigt. Die Probe ist, mit Ausnahme an der äußersten Oberfläche und vermutlich aufgrund einer sekundären Verunreinigung, beinahe frei von einem Kohlenstoffilm (organischen Verunreinigungen). Ein Oxidfilm ist an der Oberfläche gebildet. Reaktive Teilchen des Sauerstoffplasmas reagierten offensichtlich mit der Schicht von organischen Verunreinigungen und entfernten diese völlig. Während einer eher kurzen Einwirkung durch das Sauerstoffplasma wurde jedoch eine unerwünschte Oxidschicht gebildet.

Die Probe, die zuerst dem Sauerstoffplasma ausgesetzt wurde, wurde dann einem Wasserstoffplasma mit etwa 2 × 10²⁵ Radikalen pro Quadratmeter ausgesetzt. Das AES-Tiefenprofil nach der Behandlung ist in Figur 2d gezeigt. Es gibt, mit Ausnahme einer äußerst geringen Konzentration von Sauerstoff, Kohlenstoff und Schwefel und vermutlich aufgrund einer sekundären Verunreinigung nach einer Einwirkung von Luft vor der AES-Analyse, beinahe keine Verunreinigung auf der Oberfläche.

Die Messungen des elektrischen Widerstands wurden an Serien von zehn Proben durchgeführt und der durchschnittliche Widerstand der durch verschiedene Verfahren gereinigten Kupferteile wurde gemessen. Der Widerstand der Kupferbauelementproben, die mit dem nassen chemischen Vorgang gereinigt wurden, sank um etwa 16 %. Der Widerstand der Kupferproben, die mit einer Kombination aus Sauerstoff- und Wasserstoffplasma gereinigt wurden, war jedoch noch besser, da der Widerstand um etwa 28 % sank. Das wirksamste Verfahren zur Reinigung einer Kupferoberfläche ist eine kombinierte Sauerstoff-Wasserstoff-Plasmabehandlung, die zu einer faktisch verunreinigungsfreien Oberfläche ohne Oberflächenverunreinigungsfilm führt und zu einer doppelt so guten Verbesserung der elektrischen Leitfähigkeit führt. Dies ist durch AES-Tiefenprofilierung (Figur 2a, Figur 2b, Figur 2c, Figur 2d) und Messungen des elektrischen Widerstands bestätigt.

## Patentansprüche

1. Verfahren zur Behandlung von elektronischen Bauteilen, die aus Kupfer oder Nickel oder ihren Legierungen untereinander oder mit anderen Materialien wie etwa Messing hergestellt sind oder damit überzogen sind, das folgende Schritte umfaßt:
Anordnen der Bauteile in einer Behandlungskammer; Evakuieren der Behandlungskammer;
Einleiten von Sauerstoff oder Wasserdampf in die Behandlungskammer;
Sicherstellen eines Drucks im Bereich von 10⁻¹ bis 50 mbar in der Behandlungskammer und Anregen eines Plasmas in der Kammer durch einen Hochfrequenzgenerator mit einer Frequenz von mehr als etwa 1 MHz;
Einwirken von Sauerstoffradikalen auf die Bauelemente, wobei der Fluß der Radikale auf die Bauteiloberfläche mehr als etwa 10²¹ Radikale pro Quadratmeter pro Sekunde beträgt;
Auspumpen der Kammer;
Einleiten von Wasserstoff in die Behandlungskammer; Sicherstellen eines Drucks im Bereich von 10⁻¹ bis 50 mbar in der Behandlungskammer und Anregen eines Plasmas in der Kammer durch einen Hochfrequenzgenerator mit einer Frequenz von mehr als etwa 1 MHz oder Erzeugen von Wasserstoffradikalen in einer Gleichstrom-Glimmentladung;
Einwirken von Wasserstoffradikalen auf die Bauelemente, wobei der Fluß der Radikale auf die Bauteiloberfläche mehr als etwa 10²¹ Radikale pro Quadratmeter pro Sekunde beträgt.

2. Verfahren nach Anspruch 1, wobei Sauerstoff durch ein Gemisch aus einem Edelgas und Sauerstoff ersetzt ist.

3. Verfahren nach Anspruch 1, wobei Wasserdampf durch ein Gemisch aus einem Edelgas und Wasserdampf ersetzt ist.

4. Verfahren nach Anspruch 1, wobei Wasserstoff durch ein Gemisch aus einem Edelgas und Wasserstoff ersetzt ist.

5. Verfahren nach Anspruch 1, wobei das Plasma durch Bereitstellen einer Leistungsdichte von 30 bis 1000 W pro Liter des Entladungsvolumens angeregt wird.

6. Verfahren nach Anspruch 1, wobei die Gase während der Plasmabehandlungsschritte mit einer Geschwindigkeit von 100 bis 10000 sccm pro m² behandelter Oberfläche durch die Kammer hindurchgeleitet werden.

7. Verfahren nach Anspruch 1, wobei der Hochfrequenzgenerator induktiv gekoppelt ist.

8. Verfahren nach Anspruch 1, wobei die Bauelemente durch eine zusätzliche Gleichstromenergieversorgung negativ vorgespannt werden.

9. Behandlung von elektronischen Bauteilen, die aus Kupfer oder Nickel oder ihren Legierungen untereinander oder mit anderen Materialien wie etwa Messing hergestellt sind oder damit überzogen sind, umfassend zunächst eine Behandlung nach Anspruch 1 und anschließendes Kleben, Löten oder Schweißen eines anderen Materials an die so behandelte Oberfläche des elektronischen Bauteils.

## Claims

1. A method for treating electronic components, manufactured from copper or nickel or their alloys among one other or with other materials such as brass or coated therewith, comprising the following steps:
arranging said components in a treatment chamber;
evacuating said treatment chamber
applying oxygen or hydrogen into said treatment chamber;
ensuring a pressure in the range of 10⁻¹ up to 50 mbar in said treatment chamber and exciting a plasma in said chamber by means of a high frequency generator with a frequency of more than about 1 MHz;
reacting of oxygen radicals on said components in which the flow of the radicals on the component surface amounts to more than about 10²¹ radicals per square meter per second;
pumping out said chamber;
feeding hydrogen in said treatment chamber;
ensuring a pressure in the range of 10⁻¹ to 50 mbar in said treatment chamber and exciting a plasma in said chamber by means of a high frequency generator with a frequency of more than about 1 MHz or generating hydrogen radicals in a constant current glow discharge;
reacting of hydrogen radicals on the components in which the flow of the radicals on the component surface amounts to more than about 10²¹ radicals pro square meter pro second.

2. The method according to claim 1, wherein oxygen is replaced by a mixture of an inert gas and oxygen.

3. The method according to claim 1, wherein hydrogen steam is replaced by a mixture of an inert gas and water vapour.

4. The method according to claim 1, wherein hydrogen is replaced by a mixture of inert gas and hydrogen.

5. The method according to claim 1, wherein said plasma is stimulated by providing a power density of 30 to 1000 W per liter of the discharge volume.

6. The method according to claim 1, wherein said gases during the plasma treatment steps are channelled through said chamber with a speed from 100 to 10000 sccm per m².

7. The method according to claim 1, wherein said high frequency generator is inductively coupled.

8. The method according to claim 1, wherein said components are negatively biased by means of an additional direct current power supply.

9. The treatment of electronic components, manufactured from copper or nickel or their alloys among one another or with other materials such as brass or coated therewith, comprising initially a treatment according to claim 1 and subsequently adhering, soldering or welding another material on the surface thusly treated of said electronic component.

## Revendications

1. Procédé de traitement de composants électroniques qui sont fabriqués à partir de cuivre ou de nickel ou de leurs alliages réciproques ou avec d'autres matériaux, tels que le laiton, ou en sont revêtus, lequel procédé comprend les étapes suivantes:
- installation des composants dans une enceinte de traitement;
- production du vide dans l'enceinte de traitement;
- introduction d'oxygène ou de vapeur d'eau dans l'enceinte de traitement;
- établissement d'une pression comprise dans la plage allant de 10⁻¹ à 50 mbars dans l'enceinte de traitement et excitation d'un plasma dans l'enceinte, à l'aide d'un
- générateur haute fréquence d'une fréquence supérieure à environ 1 MHz ;
- action de radicaux d'oxygène sur les composants, le flux des radicaux sur la surface des composants étant supérieur à environ 10²¹ radicaux par mètre carré par seconde;
- évacuation de l'enceinte par pompage;
- introduction d'hydrogène dans l'enceinte de traitement;
- établissement d'une pression comprise dans la plage allant de 10⁻¹ à 50 mbars dans l'enceinte de traitement et excitation d'un plasma dans l'enceinte, à l'aide d'un
- générateur haute fréquence d'une fréquence supérieure à environ 1 MHz, ou génération de radicaux d'hydrogène dans une décharge lumineuse à courant continu;
- action de radicaux d'hydrogène sur les composants, le flux des radicaux sur la surface des composants étant supérieur à environ 10²¹ radicaux par mètre carré par seconde.

2. Procédé selon la revendication 1, selon lequel l'oxygène est remplacé par un mélange d'un gaz rare et d'oxygène.

3. Procédé selon la revendication 1, selon lequel la vapeur d'eau est remplacée par un mélange d'un gaz rare et de vapeur d'eau.

4. Procédé selon la revendication 1, selon lequel l'hydrogène est remplacé par un mélange d'un gaz rare et d'hydrogène.

5. Procédé selon la revendication 1, selon lequel le plasma est excité par mise à disposition d'une puissance volumique comprise entre 30 et 1000 W par litre de volume de décharge.

6. Procédé selon la revendication 1, selon lequel, pendant les étapes de traitement au plasma, les gaz sont envoyés à travers l'enceinte à une vitesse comprise entre 100 et 10 000 sccm (centimètres cubes standard) par m² de surface traitée.

7. Procédé selon la revendication 1, selon lequel le générateur haute fréquence est du type à couplage inductif.

8. Procédé selon la revendication 1, selon lequel les composants reçoivent une polarisation négative par une alimentation en énergie supplémentaire à courant continu.

9. Traitement de composants électroniques qui sont fabriqués à partir de cuivre ou de nickel ou de leurs alliages réciproques ou avec d'autres matériaux, tels que le laiton, ou en sont revêtus, comprenant d'abord un traitement selon la revendication 1, puis le collage, le brasage ou le soudage d'un autre matériau sur la surface ainsi traitée du composant électronique.
